**Europäisches Patentamt**

**European Patent Office**

**Office européen des brevets**

(19)

(11) Numéro de publication: **0 091 351**
**B1**

(12) # FASCICULE DE BREVET EUROPEEN

(45) Date de publication du fascicule du brevet:
**29.01.86**

(51) Int. Cl.⁴: **G 01 R 33/032**, H 01 S 3/10

(21) Numéro de dépôt: **83400634.8**

(22) Date de dépôt: **25.03.83**

(54) **Magnétomètre optique.**

(30) Priorité: **06.04.82 FR 8205967**

(43) Date de publication de la demande:
**12.10.83 Bulletin 83/41**

(45) Mention de la délivrance du brevet:
**29.01.86 Bulletin 86/5**

(84) Etats contractants désignés:
**DE GB IT NL**

(56) Documents cités:
**EP - A - 0 004 321**
**EP - A - 0 023 180**
**EP - A - 0 044 572**
**EP - A - 0 046 298**
**FR - A - 2 355 299**
**US - A - 4 006 989**

(73) Titulaire: **THOMSON-CSF, 173, Boulevard Haussmann,
F-75379 Paris Cedex 08 (FR)**

(72) Inventeur: **Desormiere, Bernard, THOMSON-CSF
SCPI 173, bld Haussmann, F-75379 Paris Cedex 08 (FR)**

(74) Mandataire: **Desperrier, Jean-Louis et al,
THOMSON-CSF SCPI 173, Bld Haussmann,
F-75379 Paris Cedex 08 (FR)**

ACTORUM AG

## Description

L'objet de la présente invention est un magnétomètre optique, capable de détecter des champs magnétiques faibles, de l'ordre de $10^{-5}$A/m.

Il est connu de mesurer la rotation du plan de polarisation d'une lumière rectiligne fournie par un laser en traversant un milieu magnéto-optique soumis à un champ magnétique. Cette rotation, connue sous le nom de rotation Faraday, est fonction de la valeur de la composante du champ magnétique parallèle à la direction de propagation, d'où la possibilité d'obtenir une mesure de champ par la mesure de cette rotation.

La présente invention améliore les performances des magnétomètres optiques suivant l'Art Antérieur en recouplant le faisceau optique ayant traversé le milieu dans la cavité du laser source.

Brièvement c'est un magnétomètre optique pour mesurer la composante h d'un champ magnétique suivant une direction x, comprenant une source laser fournissant une lumière polarisée rectiligne à un milieu magnéto-optique présentant l'effet Faraday, qu'elle traverse parallèlement à la direction x, caractérisé par le fait que les faisceaux optiques sortant par les deux faces $f_1$ et $f_2$ du laser traversent en sens inverse le milieu magnéto-optique et que ces deux faisceaux après cette traversée sont recouplés dans le laser, le faisceau sorti par la face $f_1$ étant recouplé par la face $f_2$ et le faisceau sorti par la face $f_2$ étant recouplé par la face $f_1$ et que le champ magnétique est mesuré à partir du courant $i_d$ fourni par un photodétecteur recevant une partie de la puissance optique du laser.

D'autres caractéristiques et avantages ressortiront de la description qui va suivre illustrée par les figures qui représentent:

figure 1, le schéma de principe du magnétomètre, suivant l'invention;

figure 2, un schéma montrant un laser avec recouplage par la lumière réfléchie;

figure 3, un schéma de magnétomètre optique avec ses circuits de traitement suivant l'invention;

figure 4, le couplage d'une fibre optique avec une couche épitaxiée de matériau ferri-magnétique;

figure 5, le schéma d'un déphaseur optique à fibre contrainte.

Le magnétomètre suivant l'invention associe un milieu magnéto-optique et un laser qui préférentiellement est un laser semi-conducteur. Il met en oeuvre la combinaison des deux effets suivants: l'effet de biréfringence circulaire magnétique, qui se produit lorsque les ondes lumineuses traversent un milieu magnéto-optique, qui est à l'origine de l'effet Faraday et l'effet de modulation de l'emission laser, par une contre-réaction optique exercée sur la cavité du laser. La mesure du champ magnétique se déduit de la mesure de l'intensité du courant en sortie d'un photodétecteur captant l'émission laser résultante.

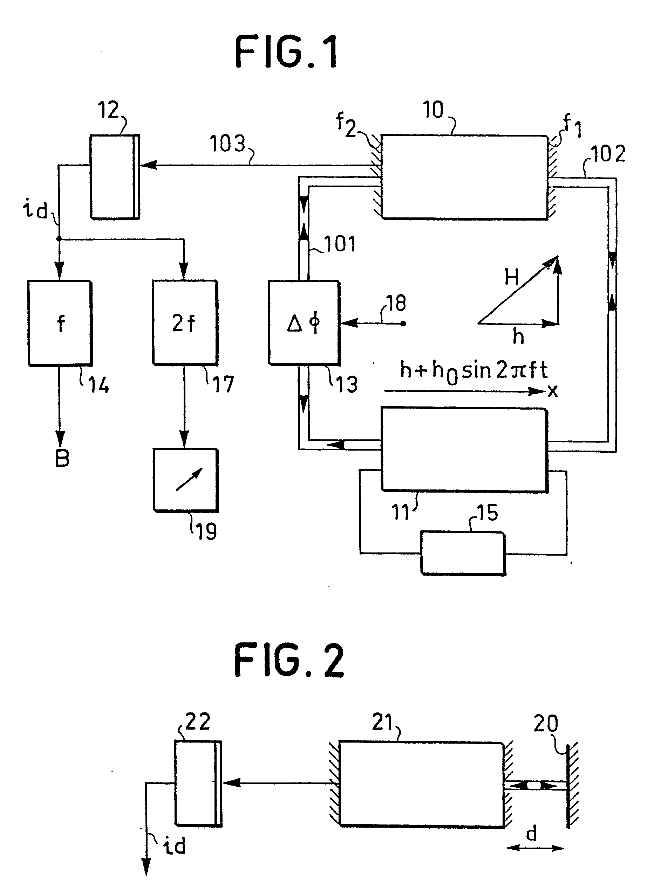

Le synoptique général du magnétomètre est représenté sur la figure 1. Il comporte une source laser à semi-conducteur 10 du type à jonction polarisée ou «diode laser». Les deux faisceaux lumineux 101 et 102, traversent un milieu magnéto-optique 11 dans des directions opposées. Chaque faisceau est renvoyé dans la cavité optique de la diode laser, de manière à y rentrer par la face opposée à celle d'émission. Ainsi, les deux faisceaux viennent interférer dans la cavité optique avec l'énergie stockée. Préférentiellement comme représenté sur la figure les faisceaux optiques se propagent dans une fibre optique.

La lumière émise par le laser, dont le courant d'injection est choisi supérieur au courant de seuil, est essentiellement polarisée rectilignement selon le mode TE; elle est monomode.

En présence d'un champ magnétique H, le milieu magnéto-optique 11 fait tourner le plan de polarisation d'une lumière rectiligne par effet de biréfringence circulaire magnétique, ou effet Faraday. La rotation Faraday étant indépendante du sens de propagation de la lumière, elle se fait dans le même sens pour les deux faisceaux 101 et 102. Le milieu magnéto-optique est choisi pour que l'angle de rotation Faraday soit poroportionnel à la composante h du champ magnétique H, parallèle à la direction de propagation x de la lumière dans le milieu. Une partie de l'émission laser résultante 103 est captée par un photodétecteur 12 pour obtenir le signal de mesure.

Pour chaque faisceau renvoyé dans la cavité, la vibration lumineuse associée a son amplitude modifiée par la rotation de Faraday, et subit un déphasage dû aux milieux optiques traversés. Sur la cavité s'exerce une double contre-réaction optique entraînant une modulation de l'intensité fournie par la diode laser, fonction de la direction du plan de polarisation. Cette intensité est fonction de l'angle de rotation Faraday et du déphasage, dont les valeurs sont identiques pour les deux faisceaux.

Un champ magnétique alternatif $h_0 \sin 2\pi ft$, est produit par le courant, parcourant une bobine, fourni par un générateur 15. Ce champ magnétique alternatif a sa direction parallèle à la propagation de la lumière et est superposé au champ h à mesurer. L'angle de rotation Faraday $\theta$ est ainsi dépendant du temps suivant la relation $\theta = A (h + h_0 \sin 2\pi ft)$, où A est une constante qui dépend du type de milieu magnéto-optique utilisé et de sa longueur.

Le courant détecté $i_d$ en sortie du photodétecteur 12 est filtré autour de la fréquence f par un filtre 14 et autour de la fréquence 2f par un filtre 17. En sortie du filtre 14, on obtient un signal B dont l'amplitude est proportionnelle à h, suivant l'expression $K_1 Ah \sin \Omega t$, où $K_1$ est un facteur de proportionnalité qui dépend du produit $Ah_0$ et du déphasage $\phi$ de l'onde lumineuse le long de la boucle de contre-réaction, entre l'entrée et la sortie de la cavité laser ($\Omega = 2\pi f$). En sortie du filtre 17, on obtient un signal dont l'amplitude est constante suivant $K_2 \cos 2\Omega t$, où $K_2$ dépend de $Ah_0$ et de $\phi$.

Il est connue que si l'on place un miroir 20 (figure 2) perpendiculairement au faisceau d'un laser 21, la puissance du laser fluctue en fonction de la distance d du miroir 20 au laser 21. Cette puissance mesurée par le détecteur 22 passe par un maximum quand l'amplitude réfléchie est en phase avec celle du laser, et par un minimum quand ces deux amplitudes sont en opposition de phase. Pour optimiser le montage de la figure 1 il est donc nécessaire d'optimiser la phase $\phi$.

En se reportant à la figure 1, un déphaseur optique 13 est introduit dans la boucle de contre-réaction pour ajuster la valeur de $\phi$ par la commande 18 de façon à rendre maximum l'amplitude du signal de sortie du filtre 17, c'est à dire $K_2$, lue sur l'indicateur 19. Cette optimisation permet de rendre également maximum le facteur $K_1$ en fonction du produit $Ah_0$, A étant fixé pour un matériau magnéto-optique donné, comme on le verra par la suite.

Ainsi, toute variation du déphasage $\phi$ sous l'effet de paramètres extérieurs, en particulier la température, n'influe pas sur la mesure de h, puisque le déphasage $\phi$ peut être ajusté en permanence pendant la mesure. De plus, le dispositif se trouve ainsi toujours réglé sur son maximum de sensibilité.

Pour réaliser le magnétomètre selon l'invention, on utilise les techniques connues de l'optique guidée. En particulier, la lumière est propagée d'une face à l'autre de la cavité laser par l'intermédiaire d'une fibre optique. Cette fibre optique est choisie de manière à conserver la polarisation de la lumière, comme par exemple décrit dans un article de R.E. WAGNER and al, Electronics Letters Vol. 17 n° 5 du 05/03/81, pages 177-178.

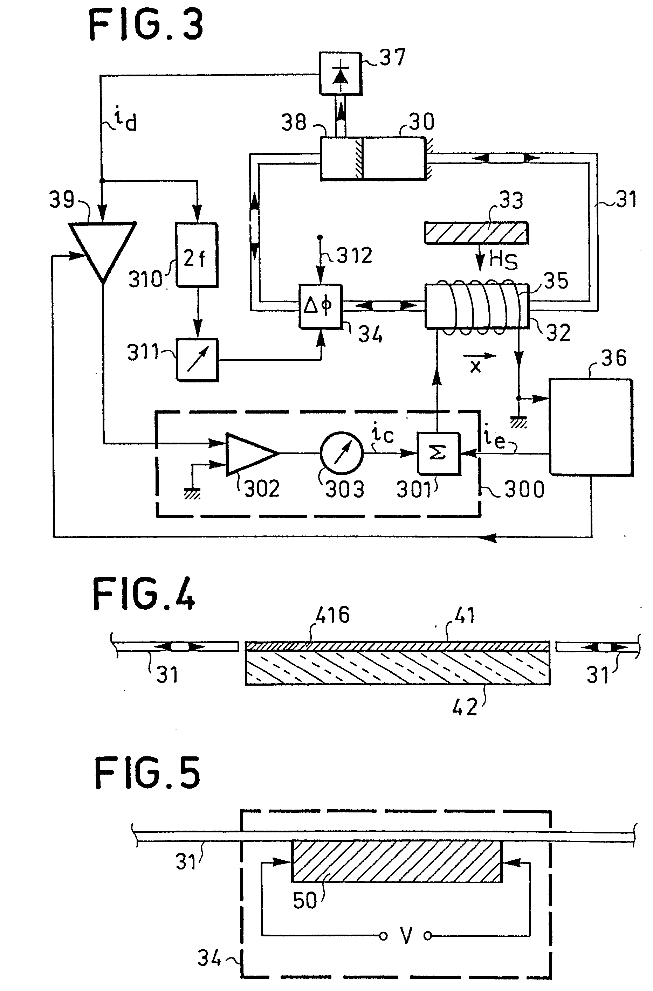

La réalisation préférée de l'invention est représentée sur la figure 3. Selon cette réalisation préférée de l'invention, une fibre optique 31 conservant la polarisation de la lumière est utilisée pour relier les deux faces de sortie d'une diode laser 30 à un milieu magnéto-optique 32. La longueur d'onde $\lambda$ de la diode laser est choisie de manière à être adaptée au milieu magnéto-optique utilisé (rapport rotation Faraday/absorption optimal).

Selon cette réalisation préférée de l'invention, le milieu magnéto-optique 32 est un matériau à aimantation spontanée du type ferri-magnétique. Pour ces matériaux, il est connu qu'en appliquant un champ magnétique $H_S$, dit de saturation, orientant tous les domaines magnétiques dans le même sens, la rotation $\theta$ est donnée par: $\theta = \dfrac{\theta_0}{H_S} Lh$, où $\theta_0$ est la rotation Faraday spécifique, obtenue pour un champ $\geqslant H_S$, L étant la longueur de matériau traversé.

La rotation $\theta$ est donc proportionnelle au champ h et la valeur A, indiquée précédemment, est égale à $\dfrac{\theta_0}{H_S} L$. En faisant une analogie avec les matériaux à aimantation induite pour lesquels la rotation est proportionnelle au champ suivant CLh, C étant la constante de Verdet du matériau, le rapport $\dfrac{\theta_0}{H_S}$ représente une constante de Verdet «apparente» $C_A$.

Cette constante $C_A$ a une valeur beaucoup plus grande que C, de l'ordre de $10^6$ fois. Il est donc intéressant, pour réduire la longueur L, d'utiliser un matériau à aimantation spontanée.

Suivant la réalisation préférée de l'invention, le matériau utilisé pour constituer le milieu magnéto-optique a les propriétés suivantes:
— grande constante «apparente» de Verdet,
— aimantation facile dans un plan,
— faible champ magnétique de saturation.

La réalisation du milieu magnéto-optique est représentée schématiquement en coupe sur la figure 4. Il est constitué avantageusement d'une couche de Grenat d'Yttrium-Fer, substitué au Gallium et au Gadolinium 41. Cette couche est obtenue par épitaxie sur un substrat 42 de Grenat de Gadolinium-Gallium, appelé GGG. Le couplage entre la couche et la fibre est obtenu directement.

Le champ de saturation $H_S$ est appliqué dans le plan de la couche 41 perpendiculairement à la direction de propagation de la lumière, au moyen d'un aimant permanent 33 ou d'un solenoïde. Il suffit d'un champ d'intensité faible, environ 80 $A/_m$, pour obtenir une couche monodomaine.

Le champ magnétique alternatif d'excitation $h_0 \sin 2\pi ft$ est appliqué au milieu magnéto-optique au moyen d'un solenoïde 35 entourant le milieu, son axe coïncidant avec la direction de propagation de la lumière. Ce solenoïde est alimenté par le générateur 36 à la fréquence f.

Le dispositif comporte une photodiode 37 qui capte une partie de la lumière sortant par l'une des faces de la diode laser, soit directement soit au moyen d'un coupleur directif à optique guidée 38, placé contre l'une des faces de la diode laser. L'intensité électrique $i_d$, fournie par la photodiode, est filtrée autour de la fréquence f et démodulée par un amplificateur à détection synchrone 39 recevant le courant de référence du générateur 36. Cette intensité est également filtrée autour de la fréquence 2f en 310. La composante de $i_d$ à la fréquence f est envoyée dans un ensemble de circuits 300 fournissant la valeur du champ h, à mesurer par une méthode de zéro. Au champ magnétique $h_0$, est superposé un champ magnétique de compensation, par injection d'un courant $i_c$ continu ou très basse fréquence, dans la bobine 35; ce courant s'ajoute au courant d'excitation $i_e$ dans le sommateur 301. Il est obtenu en sortie d'un amplificateur différentiel 302, qui reçoit la composante démodulée de $i_d$ à la fréquence f. La mesure du champ est obtenue directement sur l'indicateur 303, qui symbolise tout système de prise de données utilisé en pareil cas.

Le dispositif comporte un déphaseur optique variable 34 représenté figure 5. Ce déphaseur est réalisé au moyen d'un support piézoélectrique 50 en forme de plaquette, sur lequel est collée la fibre optique 31 de manière à la rendre solidaire du support. Une tension variable V est appliquée aux bornes de la plaquette et les variations de chemin optique qui en résultent permettent d'ajuster le déphasage. Avant la mesure, le déphaseur est commandé de 312 de manière à rendre maximum l'amplitude du signal issu du filtre 301 indiquée par le circuit 311. Pendant la mesure, ce circuit 311 commande automatiquement le déphaseur, de manière à maintenir cette amplitude au maximum. Suivant une variante de l'invention le milieu magnéto-optique est constitué par la fibre optique de transmission elle-même. La constante de Verdet des matériaux constituant les fibres étant en général de valeur faible, la fibre a une grande longueur, de l'ordre de plusieurs centaines de mètres, pour obtenir une sensibilité suffisante. La fibre est donc enroulée sous forme de bobine plate de manière à former des spires, qui sont placées à l'intérieur de la bobine d'excitation, le champ $H_S$ de saturation transverse n'étant alors plus nécessaire.

Le dispositif tel que décrit précédemment permet de détecter des variations relatives de la composante $i_d$ de l'ordre de $10^{-6}$.

La longueur d'onde d'émission laser est par exemple égale à 1,2 µm et le diamètre du coeur de la fibre optique égal à 5 µm environ.

Avec un milieu magnéto-optique constitué d'une couche mince de GaGdYIG, les caractéristiques sont les suivantes:

— $\theta_0 = 4,3 \cdot 10^2$ rad/m
— $H_S = 80$A/m
— $L = 1$ cm
— $h_0 = 24$A/m
— h minimum détectable $= 10^{-5}$A/m

Avec un milieu magnéto-optique constitué d'une fibre de silice, les caractéristiques sont les suivantes:

— constante de Verdet $C = 1,1 \times 10^{-6}$ rad/m/(A/m)
— $L = 1000$ m
— $h_0 = 130$A/m
— h minimum détectable $= 3 \times 10^{-4}$A/m

## Revendications

1. Magnétomètre optique pour mesurer la composante h d'un champ magnétique suivant une direction x, comprenant une source laser (10) fournissant une lumière polarisée rectiligne à un mulieu magnéto-optique (11) présentant l'effet Faraday, qu'elle traverse parallèlement à la direction x, caractérisé par le fait que les faisceaux optiques sortant par les deux faces $f_1$ et $f_2$ du laser (10) traversent en sens inverse le milieu magnéto-optique (11) et que ces deux faisceaux après cette traversée sont recouplés dans le laser, le faisceau sorti par la face $f_1$ étant reecouplé par la face $f_2$ et le faisceau sorti par la face $f_2$ étant recouplé par la face $f_1$ et que le champ magnétique est mesuré à partir du courant $i_d$, fourni par un photodétecteur (12) recevant une partie de la puissance optique du laser (10).

2. Magnétomètre suivant la revendication 1, caractérisé par le fait que les faisceaux se propagent des faces $f_1$ et $f_2$ au milieu magnéto-optique dans des fibres optiques conservant la polarisation.

3. Magnétomètre suivant la revendication 1 ou 2, caractérisé par le fait qu'un champ alternatif parallèle à x à la fréquence f est superposé au champ h.

4. Magnétomètre suivant la revendication 3, caractérisé par le fait que le courant fourni par le photodétecteur $i_d$ est appliqué à des filtres centrés sur les fréquences f et 2f (14, 17).

5. Magnétomètre suivant la revendication 1, caractérisé par le fait qu'il comporte un déphaseur optique (13) réglable placé sur les trajets optiques.

6. Magnétomètre suivant la revendication 5, caractérisé par le fait que le déphaseur (13) est réglé pour obtenir un déphasage total dans la boucle, rendant maximum la composante de $i_d$ à la fréquence 2f.

7. Magnétomètre suivant les revendications 2 et 5, caractérisé par le fait que le déphaseur (34) comporte un support piézoélectrique (50) sur lequel est fixé la fibre optique (31) propageant les faisceaux et que le déphasage est obtenu par application d'une tension (V) sur le support piézoélectrique (50).

8. Magnétomètre suivant la revendication 3, caractérisé par le fait que la composante à la fréquence f du courant $i_d$ est utilisée pour générer dans le milieu magnéto-optique un champ magnétique, compensant à chaque instant le champ à mesurer et que la mesure de la composante h du champ est obtenue directement par lecture du courant de compensation.

9. Magnétomètre suivant la revendication 1, caractérisé par le fait que le milieu magnéto-optique est un matériau ferri-magnétique à aimantation spontanée facile dans un plan.

10. Magnétomètre suivant la revendication 9, caractérisé par le fait qu'il comporte un aimant permanent (33) produisant un champ magnétique de saturation dans le plan d'aimantation facile du matériau et perpendiculaire à la direction de propagation.

11. Magnétomètre suivant la revendication 10, caractérisé par le fait que le milieu magnéto-optique est constitué d'une couche mince de Grenat d'Yttrium-fer avec substitution de gallium et de gadolinium (Ga Gd YIG) épitaxié sur le Grenat de Gadolinium Gallium (GGG).

12. Magnétomètre suivant la revendication 1, caractérisé par le fait que le milieu magnéto-optique est un matériau paramagnétique à aimantation induite.

13. Magnétomètre suivant la revendication 12, caractérisé par le fait que le milieu magnéto-optique est constitué d'une fibre optique paramagnétique.

14. Magnétomètre suivant la revendication 1, caractérisé par le fait que le laser est un laser semi-conducteur émettant une longueur d'onde dans le domaine de transparence du matériau magnéto-optique et présentant un rapport rotation Faraday sur absorption optimal.

## Patentansprüche

1. Optisches Magnetometer zur Messung der Komponente h eines Magnetfeldes in einer Richtung x, mit einer Laserquelle (10), die geradlinig polarisiertes Licht einem magnetooptischen Medium (11) zuführt, welches den Faraday-Effekt aufweist und parallel zur Richtung x durchquert wird, dadurch gekennzeichnet, dass die optischen Bündel, welche aus den zwei Flächen $f_1$ und $f_2$ des Lasers (10) austreten, das magnetooptische Medium (11) gegenläufig durchqueren, und dass diese zwei Bündel nach der Durchquerung in dem Laser wieder gekoppelt werden, wobei das durch die Fläche $f_1$ austretende Bündel durch die Fläche $f_2$ wieder eingekoppelt wird und das durch die Fläche $f_2$ austretende Bündel durch die Fläche $f_1$ wieder eingekoppelt wird, und dass das Magnetfeld ausgehend von dem Strom $i_d$ gemessen wird, den ein Fotodetektor (12) liefert, welcher einen Teil der optischen Leistung des Lasers (10) empfängt.

2. Magnetometer nach Anspruch 1, dadurch gekennzeichnet, dass die Bündel sich von den Flächen $f_1$ und $f_2$ ausgehend zu dem magnetooptischen Medium in optischen Fasern ausbreiten, welche die Polarisation bewahren.

3. Magnetometer nach Anspruch 1 oder 2, dadurch gekennzeichnet, dass ein zur Achse x paralleles Wechselfeld der Frequenz f dem Feld h überlagert ist.

4. Magnetometer nach Anspruch 3, dadurch gekennzeichnet, dass der vom Fotodetektor $i_d$ gelieferte Strom an Filter angelegt ist, welche auf die Frequenzen f und 2f zentriert sind (14, 17).

5. Magnetometer nach Anspruch 1, dadurch gekennzeichnet, dass es einen einstellbaren optischen Phasenschieber (13) umfasst, der auf den optischen Wegen angeordnet ist.

6. Magnetometer nach Anspruch 5, dadurch gekennzeichnet, dass der Phasenschieber (13) derart eingestellt ist, dass eine Gesamtphasenverschiebung in der Schleife erhalten wird, durch welche die Komponente von $i_d$ bei der Frequenz 2f minimal gemacht ist.

7. Magnetometer nach Ansprüchen 2 und 5, dadurch gekennzeichnet, dass der Phasenschieber (34) einen piezoelektrischen Träger (50) umfasst, auf welchem die optische Faser (31) befestigt ist, durch welche die Bündel sich ausbreiten, und dass die Phasenverschiebung dadurch erhalten ist, dass eine Spannung (V) an dem piezoelektrischen Träger (50) angelegt ist.

8. Magnetometer nach Anspruch 3, dadurch gekennzeichnet, dass die Komponente des Stromes $i_d$ bei der Frequenz f verwendet wird, um in dem magnetooptischen Medium ein Magnetfeld zu erzeugen, welches jederzeit das zu messende Feld kompensiert, und dass die Messung der Komponente h des Feldes direkt durch Ablesen des Kompensationsstromes erhalten wird.

9. Magnetometer nach Anspruch 1, dadurch gekennzeichnet, dass das magnetooptische Medium ein ferrimagnetisches Material mit spontaner leichter Magnetisierung in einer Ebene ist.

10. Magnetometer nach Anspruch 9, dadurch gekennzeichnet, dass es einen Permanentmagnet (33) enthält, der ein Sättigungsmagnetfeld in der Ebene leichter Magnetisierung des Materials senkrecht zur Ausbreitungsrichtung erzeugt.

11. Magnetometer nach Anspruch 10, dadurch gekennzeichnet, dass das magnetooptische Medium aus einer Dünnschicht eines Yttrium-Eisen-Granates mit Gallium- und Gadolinium-Substitution (Ga Gd YIG) gebildet ist, die epitaktisch auf dem Gadolinium-Gallium-Granat (GGG) aufgebracht ist.

12. Magnetometer nach Anspruch 1, dadurch gekennzeichnet, dass das magnetooptische Medium ein paramagnetisches Material mit induzierter Magnetisierung ist.

13. Magnetometer nach Anspruch 12, dadurch gekennzeichnet, dass das magnetooptische Medium durch eine paramagnetische optische Faser gebildet ist.

14. Magnetometer nach Anspruch 1, dadurch gekennzeichnet, dass der Laser ein Halbleiterlaser ist, welcher eine Wellenlänge im Durchlässigkeitsgebiet des magnetooptischen Materials aussendet, mit einem optimalen Verhältnis der Faraday-Drehung zur Absorption.

**Claims**

1. Optical magnetometer for measuring the component h of a magnetic field in a direction x, comprising a laser source (10) supplying a linearly polarized light to a magneto-optical medium (11) presenting the Faraday effect and which it traverses in parallel to the direction x, characterized by the fact that the optical beams emerging from the two faces $f_1$ and $f_2$ of the laser (10) traverse the magneto-optical medium (11) in opposite senses and that the two beams after traversing are coupled again in the laser, the beam emerging from the face $f_1$ being coupled in by the face $f_2$ and the beam emerging from the face $f_2$ being coupled in by the face $f_1$, and in that the magnetic field is measured from the current $i_d$ supplied by a photodetector (12) receiving a portion of the optical power of the laser (10).

2. Magnetometer according to claim 1, characterized by the fact that the beams propagate from the faces $f_1$ and $f_2$ towards the magneto-optical medium within optical fibers maintaining the polarization.

3. Magnetometer according to claims 1 or 2, characterized by the fact that an alternating field parallel to x and of the frequency f is superimposed on the field h.

4. Magnetometer according to claim 3, characterized by the fact that the current supplying by the photodetector $i_d$ is applied to filters centered on the frequencies f and 2f (14, 17).

5. Magnetometer according to claim 1, characterized by the fact that it comprises an adjustable optical phase shifter (13) placed on the optical paths.

6. Magnetometer according to claim 5, characterized by the fact that the phase shifter (13) is adjusted to obtain an overall phase shift in the loop whereby the component $i_d$ at the frequency 2f is maximum.

7. Magnetometer according to claims 2 and 5, characterized by the fact that the phase shifter (34) comprises a piezoelectric carrier (50) whereupon the optical fiber (31) propagating the beams is fixed and that the phase shift is obtained by applying a voltage (V) to the piezoelectric carrier (50).

8. Magnetometer according to claim 3, characterized by the fact that the component of frequency f of the current $i_d$ is used to generate a magnetic field in the magneto-optical medium whereby the field to be measured is compensated for at each moment and that the measurement of the component h of the field is obtained directly by reading the compensation current.

9. Magnetometer according to claim 1, characterized by the fact that the magneto-optical medium is a ferrimagnetic material with spontaneous easy magnetization in a plane.

10. Magnetometer according to claim 9, characterized by the fact that it comprises a permanent magnet (33) producing a magnetic saturation field in the plane of easy magnetization of the material and perpendicularly to the direction of propagation.

11. Magnetometer according to claim 10, characterized by the fact that the magneto-optical medium is formed of a thin layer of yttrium-iron garnet with substitution of gallium and gadolinium (Ga Gd YIG) epitaxially grown on the gadolinium gallium garnet (GGG).

12. Magnetometer according to claim 1, characterized by the fact that the magneto-optical medium is a paramagnetic material with induced magnetization.

13. Magnetometer according to claim 12, characterized by the fact that the magneto-optical medium is formed of an optical paramagnetic fiber.

14. Magnetometer according to claim 1, characterized by the fact that the laser is a semiconductor laser emitting a wavelength in the range of transparency of the magneto-optical material and having an optimum ratio of the Faraday rotation to the absorption.

# FIG.1

# FIG.2

# FIG.3

# FIG.4

# FIG.5